# EUROPEAN PATENT SPECIFICATION

(11) **EP 1 662 020 B1**
(45) Date of publication and mention of the grant of the patent: **14.05.2008**
(21) Application number: 06004367.6
(22) Date of filing: 29.06.2004
(51) Int. Cl.: C23C 16/00

(54) **Method for producing a copper thin film**
Verfahren zur Herstellung einer dünnen Kupferschicht
Méthode de production d'une couche mince de cuivre

(30) Priority: 03.07.2003 JP 2003270570
(43) Date of publication of application: 31.05.2006
(62) Divisional of application: 04015238.1
(73) Proprietor: MEC COMPANY LTD., Amagasaki-shi, Hyogo 660-0832 (JP)
(72) Inventor: Otani, Minoru, Amagasaki-shi Hyogo 660-0832 (JP); Hisada, Jun, Amagasaki-shi Hyogo 660-0832 (JP); Mawatari, Toyoki, Amagasaki-shi Hyogo 660-0832 (JP)
(74) Representative: Grape & Schwarzensteiner

(56) References cited:
- EP-A- 0 980 097

## Description

The present invention relates to a method for producing a copper thin film. More specifically, the present invention relates to a method for producing a copper thin film useful for forming wiring of an electronic device and the like.

Conventionally, as a method for industrially forming a copper thin film on a non-conductive substrate, electroless copper plating generally is used. For example, in the course of producing a printed board, a conductive copper thin film is formed on a substrate by electroless copper plating, and thereafter, the copper thin film thus formed is subjected to electrolytic copper plating, whereby a copper thin film with a thickness required for copper wiring is formed.

However, formaldehyde, which may be carcinogenic, is used for a plating bath used in the electroless copper plating. This causes problems in an operation environment and disposal of liquid wastes.

Furthermore, in the course of producing a solar battery, a semiconductor device, an electronic display device, and the like, copper wiring is formed by a vacuum process such as sputtering, vacuum evaporation, CVD, or the like.

These methods require a large-scale vacuum evaporator. Furthermore, these methods have low productivity and high cost due to a vacuum batch treatment.

JP2000-123634A proposes forming a copper thin film by coating a substrate with a dispersion of ultra-fine copper particles, and sintering it at 300°C to 400°C.

However, according to the above-mentioned conventional technique sintering is performed at a high temperature, so that it is not applicable to an organic substrate having a low heat resistant temperature.

Therefore, with the foregoing in mind, it is an object of the present invention to provide a method of forming a copper thin film required in the course of producing an electronic device or the like safely, inexpensively, and easily and a method for producing a copper thin film using the copper compound.

The inventors of the present invention studied various organic metal compounds, and consequently, found that a copper compound represented by the following Formula (1) is decomposed at a relatively low temperature of 100°C to 300°C to allow metallic copper to be precipitated, and forms a copper thin film, thereby achieving the present invention.

More specifically, the present invention relates to a method of forming a copper thin film using a copper compound having a decomposition temperature in a range of 100°C to 300°C and comprising one unit or oligomeric or polymeric units represented by the following Formula (1):

[R¹COO]ₙ[NH₃]ₘCuX¹ₚ (1)

where *n* is 1 to 3; *m* is 1 to 3; *p* is 0 to 1; *n* pieces of *R¹* respectively represent the following Formula (2), CH₂X², CH₂X²(CHX₂)_{q}, NH₂, or H, and may be the same or different from each other, or *n* is 2 and two pieces of [R¹COO] represent together the following Formula (3); *R², R³*, and *R⁴* are respectively CH₂X², CH₂X²(CHX²)_{q}, NH₂, or H; R⁵ is -(CHX²)ᵣ-; X² is H, OH, or NH₂; *r* is 0 to 4; *q* is 1 to 4; and *X¹* is NH₄⁺, H₂O, or solvent molecules

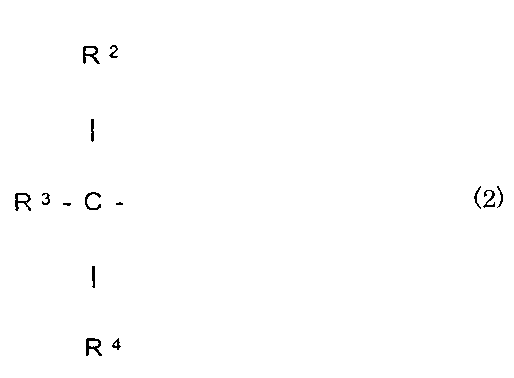

[-OOC-R⁵-COO-] (3).

The method for producing a copper thin film of the present invention is characterized by heating the copper compound at 100° to 300°C in a non-oxidizing atmosphere of copper, and cooling the copper compound to 60°C or lower to form a copper thin film.

These and other advantages of the present invention will become apparent to those skilled in the art upon reading and understanding the following detailed description with reference to the accompanying figures.

FIG. 1 is an infrared (IR) analysis chart of a precipitate obtained in Example 1 of the present invention.

FIG. 2 is a thermogravimetry (TG) chart of a copper compound obtained in Example 1 of the present invention.

FIG. 3 is a powder X-ray diffraction chart of the copper compound obtained in Example 1 of the present invention.

FIG. 4 is an electron spectroscopic chemical analysis (ESCA) chart of a copper thin film obtained in Example 3 of the present invention.

The copper compound used according to the present invention is composed of a unit represented by the above-mentioned Formula (1). The copper compound may be composed of one unit or at least two connected units represented by the above-mentioned Formula (1). In the case where the copper compound is composed of at least two connected units, the number thereof has no upper limit in the same way as in an inorganic substance.

An example of the unit represented by the above-mentioned Formula (1) includes a copper compound composed of one unit or oligomer or polymer of units represented by the following Formula (4):

[HCOO]ₙ[NH₃]ₘCUX¹ₚ (4)

(where *n* is 1 to 3; *m* is 1 to 3; *p* is 0 to 1; and *X¹* is NH₄⁺, H₂O, or solvent molecules).

Another example of the unit represented by the above-mentioned Formula (1) includes a copper compound composed of one unit or an oligomer or polymer of units represented by the following Formula (5):

[HCOO]₂[NH₃]₂CuX³ₚ (5)

(where *p* is the same as the above; and *X³* is H₂O or solvent molecules).

Still another example of the unit represented by the above-mentioned Formula (1) includes a copper compound composed of one unit or an oligomer or polymer of units represented by the following Formula (6):

[R¹COO]₂[NH₃]₂Cu (6)

(where two pieces of *R¹* may be the same as the above or different therefrom).

Still another example of the unit represented by the above-mentioned Formula (1) includes a copper compound composed of one unit or an oligomer or polymer of units represented by the following Formula (7):

[OOC-R⁵-COO] [NH₃]₂Cu (7)

(where R⁵ is the same as the above).

The solvent molecules refer to those of a solvent used for producing a copper compound, a solvent used for forming a copper compound into a solution for coating, and the like. Examples of the solvent molecules include those of methanol, ethanol, dimethyl sulfoxide, dichloromethane, chloroform, and the like.

There is no particular limit to a method for producing the copper compound. For example, the copper compound can be produced by reacting ammonia water with a compound of carboxylic acid and copper, such as copper formate. The copper compound also can be produced by reacting carboxylic acid such as formic acid with copper oxide, and thereafter, reacting ammonia water with the resulting product.

The copper compound is useful for producing a copper thin film. More specifically, the copper compound is decomposed by providing energy such as heat, light, or the like to the copper compound in the vicinity of a substrate, whereby a copper thin film can be formed easily on the surface of the substrate.

There is no particular limit to the substrate, and various substrates can be used. Examples of the substrate include thermosetting resin such as polyimide, epoxy resin, bismaleimide • triazine resin, denatured polyphenylene ether, and the like; thermoplastic resin such as ABS resin, polyamide, polyethylene, polyvinylchloride, fluorine resin, a liquid polymer, and the like; ceramics; silicon; glass; metal; paper and fabric made of natural fibers or synthetic fibers; wood; and the like. The substrate may be a pre-preg substrate in which reinforcing fibers such as glass fibers or synthetic fibers are impregnated with resin. There is no particular limit to the shape of the substrate, and the substrate may be in the form of a film, a line, a bar, a tube, a plate, a porous material, or the like.

The substrate may be subjected to surface reforming by cleaning, chemical treatment, physical treatment, or the like, if required, for the purpose of enhancing the adhesion with a copper thin film.

Next, a method for producing a copper thin film of the present invention will be described. According to the production method of the present invention, first, the copper compound is heated at 100°C to 300°C in a non-oxidizing atmosphere of copper, and then, cooled to 60°C or lower to form a copper thin film. The non-oxidizing atmosphere preferably is at least one selected from the group consisting of a reducing atmosphere, an inert atmosphere, a reduced-pressure atmosphere, and a supercritical atmosphere of a reducing gas and an inert gas. The heating temperature may be at least the decomposing temperature of a copper compound. A preferable heating temperature will depend upon the type of a copper compound, the atmosphere during heating, and the like, and is set appropriately in accordance therewith. When the heating temperature is too high, in the case where the heat resistant temperature of a substrate is low, the substrate may be degraded, or energy may be wasted. In a preferable example, the copper compound can be decomposed by heating at 140°C to 200°C.

There is no particular limit to the heating method, and a method suitable for a heating atmosphere may be selected. For example, the copper compound can be heated with a heater, a laser, or the like.

Examples of the reducing atmosphere include hydrogen, carbon monoxide, ammonia gas, and the like; and an atmosphere in which hydrogen, carbon monoxide, ammonia gas, or the like is mixed with inert gas such as nitrogen, helium, argon, carbon dioxide, or the like.

Furthermore, examples of the inert atmosphere include nitrogen, helium, argon, carbon dioxide, and the like.

According to an exemplary production method, a copper compound is placed at an interval so as to be opposed to a substrate in a sealed container, and the copper compound is decomposed by heating under a reduced pressure to vapor-deposit copper on the opposed substrate, whereby a copper thin film can be formed on the surface of the substrate (hereinafter, referred to as a "copper thin film forming method A").

For example, the pressure is reduced preferably to 10 kPa or less, and more preferably 1 kPa or less with a vacuum pump.

The conditions such as an atmospheric pressure, a heating time, and the like can be set arbitrarily in accordance with the distance between the copper compound and the substrate, the thickness of an intended copper thin film, and the like. The heating temperature can be set arbitrarily in a range of 100°C to 300°C.

After predetermined heating is performed, the copper compound is cooled to 60°C or lower, and the reduced pressure is eliminated. When the reduced pressure is eliminated before cooling to 60°C or lower, the copper thin film is oxidized, and a thin film of metallic copper cannot be obtained.

When the copper compound is placed in the sealed container, only the copper compound may be placed, or a solution, a dispersion, a paste, or the like in which the copper compound is dissolved or dispersed in a solvent or the like may be placed.

There is no particular limit to the solvent. Any solvent may be used as long as it does not inhibit the decomposition reaction of the copper compound, and those which volatilize before the copper compound is decomposed are preferable. Examples of the solvent include alcohols such as methanol, ethanol, propanol, butanol, and the like; glycol ethers such as ethylene glycol monomethyl ether, diethylene glycol monomethyl ether, propylene glycol monomethyl ether, and the like; ketones such as acetone, methyl ethyl ketone, and the like; a hydrocarbon solvent such as pentane, hexane, benzene, toluene, and the like; an ether solvent such as diethyl ether, tetrahydrofuran, p-dioxane, and the like; a halogen solvent such as methylene chloride, chloroform, and the like; and a terpene solvent such as limonene, geraniol, terpineol, linalool, and the like. These solvents may be used alone or in combination of two or more kinds.

In addition to a solvent, various additives may be used for the solution, dispersion, and paste, as long as the function of the copper thin film may not be impaired. For example, a thickener for regulating the viscosity of a solution, a surfactant for enhancing wettability, and the like can be used.

Furthermore, a copper thin film also can be formed on the surface of a substrate, for example, by placing the copper compound in a sealed container so as to bring it into contact with the surface of a substrate, and heating it under a gentle reduced pressure (hereinafter, referred to as a "copper thin film forming method B"). Regarding the gentle reduced pressure, for example, a pressure is reduced preferably to 90 to 1 kPa, and more preferably to 50 to 5 kPa, with an aspirator.

The conditions such as an atmospheric pressure, a heating time, and the like can be set arbitrarily in accordance with a method for placing a copper compound, the thickness of an intended copper thin film, and the like. The heating temperature can be set arbitrarily in a range of 100°C to 300°C.

After predetermined heating is performed, the copper compound is cooled to 60°C or lower while keeping the atmosphere during heating, and the reduced pressure is eliminated, in the same way as in the copper thin film forming method A.

Even according to the copper thin film forming method B, only the copper compound may be placed, or a solution, a dispersion, a paste, or the like in which the copper compound is dissolved or dispersed in a solvent or the like may be placed.

There is no particular limit to a method for placing a copper compound in contact with the surface of a substrate. For example, electrostatic printing is used in the case where the copper compound is powder; spin coating, dip coating, curtain coating, roll coating, spray coating, ink-jet printing, screen printing, and the like can be used in the case where the copper compound is a solution or a dispersion; and screen printing can be used in the case where the copper compound is a paste.

There is no particular limit to the solvent, and the same solvent as that in the copper thin film forming method A can be used. Furthermore, in the same way as in the copper thin film forming method A, various kinds of additives may be used, in addition to a solvent, for the solution, dispersion, and paste. By regulating the viscosity of the solution or the like, the thickness of a coating film can be regulated, and the thickness of a copper thin film thus obtained can be regulated. The thickness of a film can be adjusted, for example, in a range of 0.01 to 10 µm

Furthermore, in the copper thin film forming method B, heating may be performed in a reducing atmosphere or an inert atmosphere, in place of the gentle reduced-pressure atmosphere.

Examples of the reducing atmosphere include hydrogen, carbon monoxide, ammonia gas, and the like; and an atmosphere in which hydrogen, carbon monoxide, ammonia gas, or the like is mixed with inert gas such as nitrogen, helium, argon, carbon dioxide, or the like.

Furthermore, examples of the inert atmosphere include nitrogen, helium, argon, carbon dioxide, and the like.

As described above, according to the method for producing a copper thin film of the present invention, the heating temperature is relatively low. Therefore, when this method is used for forming copper wiring of a printed board using an organic substrate having a low heat resistant temperature, such as thermosetting resin (e.g., polyimide, epoxy resin, bismaleimide • triazine resin, denatured polyphenylene ether, etc.), and thermoplastic resin (e.g., ABS resin, polyamide, polyethylene, polyvinylchloride, fluorine resin, a liquid crystal polymer, etc.), a copper thin film can be formed without degrading the substrate.

The copper wiring also may be formed as follows.
(1) A copper thin film is formed over the entire surface of a substrate, and thereafter, the copper thin film is etched, leaving a wiring portion, by photoetching.
(2) A copper thin film is formed over the entire surface of a substrate, and thereafter, the copper thin film thus formed is used as a power supplying layer and entirely plated with copper. Then, the resultant copper thin film is etched, leaving a wiring portion, by photoetching.
(3) A copper thin film is formed over the entire surface of a substrate, and thereafter, the copper thin film thus formed is used as a power supplying layer and pattern-plated by a semi-additive method.
(4) A substrate is covered with a mask having a negative pattern of wiring, and copper is vapor-deposited thereon.
(5) A solution or a paste of a copper compound is printed through screening of a negative pattern of wiring, followed by heating.

Copper wiring also can be formed on a silicon substrate, a glass substrate, or the like without using a large-scale vacuum evaporator. This is very useful for producing a solar battery, a semiconductor device, an electronic display, and the like.

Furthermore, the method for producing a copper thin film of the present invention can be used for any of ornaments, furniture, construction materials, and the like, as well as an electronic component.

Unlike the conventional method for producing a copper thin film by a vacuum process such as sputtering, vacuum evaporation, CVD, or the like, and plating, an industrial method for forming a copper thin film easily by heat-treating a particular compound can be provided.

### Examples

The present invention will be described in more detail by way of examples. The present invention is not limited to the examples.

### Example 1

First, 1 mol of copper formate • tetrahydrate and 2 mol of ammonia water were added to methanol, and the mixture thus obtained was stirred at room temperature (25°C) for one hour. An insoluble was filtered, and the methanol solution thus obtained was concentrated and allowed to stand, whereby a blue precipitate was obtained. The precipitate was filtered and dried under reduced pressure.

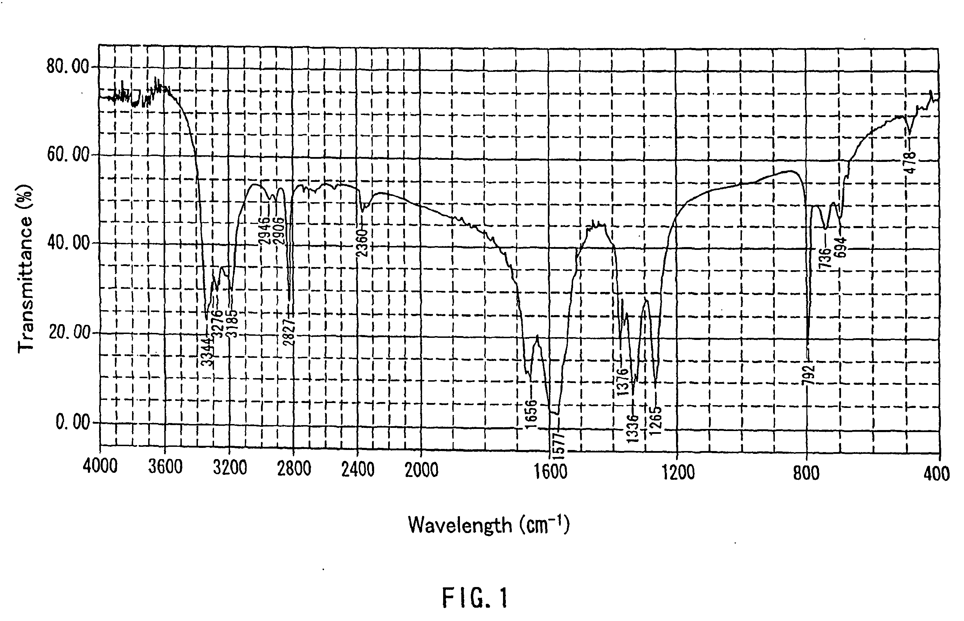

FIG. 1 shows the results obtained by subjecting the resultant precipitate to infrared (IR) analysis. In FIG. 1, a peak presumed to be the absorption of a carbonyl group and ammonia was recognized.

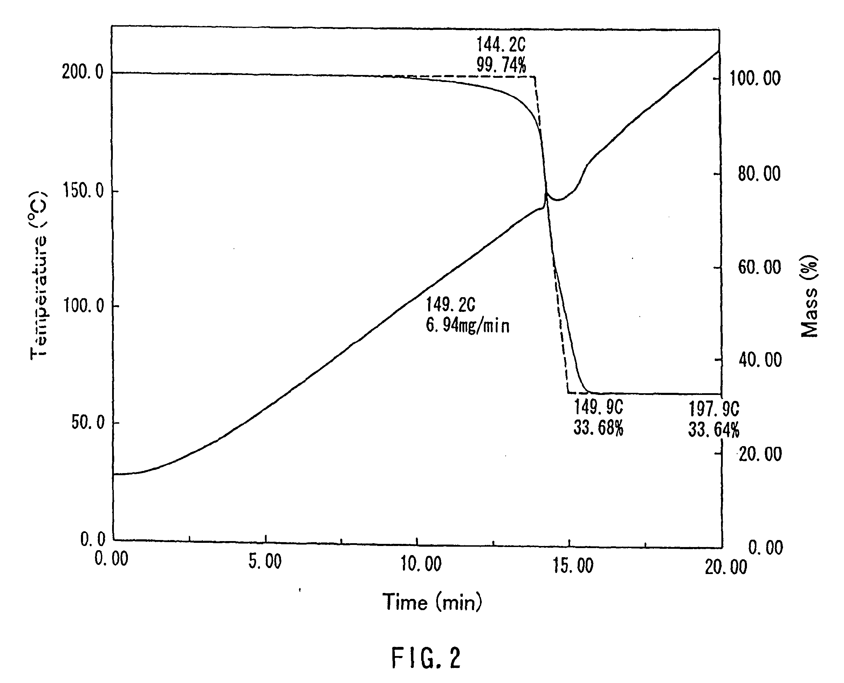

Furthermore, the blue precipitate was heated at a temperature-rising speed of 10°C/min. in a nitrogen gas atmosphere, and subjected to thermal analysis by thermogravimetry (TG). FIG. 2 shows the results of thermal analysis by thermogravimetry (TG). It is understood from FIG. 2 that there is a great reduction in weight due to the decomposition at about 150°C.

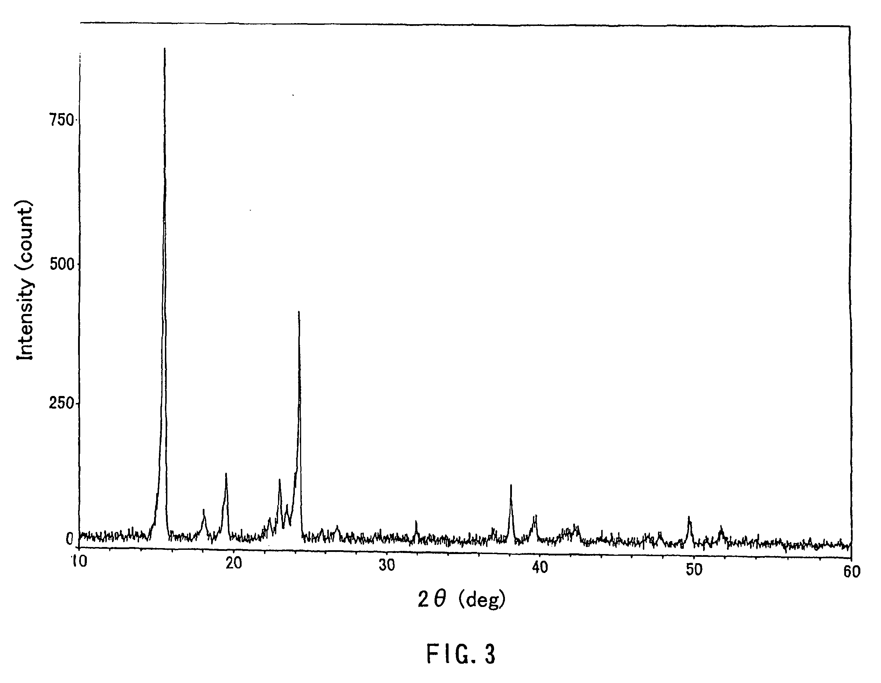

The resultant precipitate was analyzed by a powder X-ray diffraction method. FIG. 3 shows the results. Furthermore, the content of copper was checked to be 33.91% by weight by atomic absorption spectrometry.

Next, the blue precipitate was dissolved in methanol, and a methanol solution was added gently to a sample tube containing dichloromethane. Thereafter, the sample tube was sealed and allowed to stand for 5 days, whereby blue needle-shaped single crystal and a pale powdery precipitate were obtained.

The blue needle-shaped single crystal was subjected to the elementary analysis and the X-ray structure analysis. Table 1 shows the results of the elementary analysis of carbon, hydrogen, and nitrogen.

**Table 1**

| | C | H | N | Cu |
|---|---|---|---|---|
| Theoretical value | 12.80 | 4.26 | 14.94 | 33.88 |
| Actually measured value 1 | 12.8 | 4.4 | 14.5 - | |
| Actually measured value 2 | 12.8 | 4.4 | 14.6 - | |

| | | | | |
|---|---|---|---|---|
| (Remark) Each numerical value is represented as % by mass. | | | | |

From the above results of atomic absorption spectrometry, elementary analysis, and X-ray structure analysis, the blue needle-shaped single crystal was confirmed to be
Catena- [(µ-formato-o,o')-bis(ammine)(formato-o) Copper(II)] (the following Formula (8)). 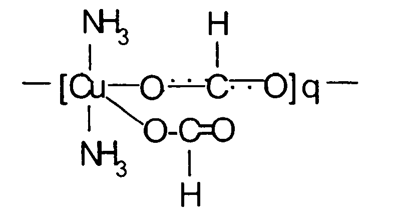 (where q is a positive integer).

A diffraction diagram of powder X-ray diffraction was simulated from the above structure, and the simulation was substantially matched with the actually measured result shown in FIG. 3.

### Example 2

First, 1 mol of copper oxide (I) and 4 mol of ammonium formate were added to methanol, and the mixture thus obtained was stirred at room temperature for 4 hours. Insoluble material was filtered. Ethyl acetate was added to the methanol solution thus obtained, and allowed to stand, whereby a blue precipitate was obtained. The precipitate was filtered and dried under reduced pressure.

The precipitate thus obtained was subjected to IR analysis, whereby the absorption of a carbonyl group and ammonia was recognized. Furthermore, as a result of thermal analysis, the great reduction in weight due to the decomposition was recognized at about 145°C.

### Example 3

The blue precipitate obtained in Example 1 was spread uniformly to 10 g/m² on a stainless steel plate. The precipitate on the stainless steel plate and a polyimide film were fixed with a stainless steel jig so that they were opposed to each other at an interval of 15 mm. The precipitate and the polyimide film thus fixed were placed in a vacuum oven, and the pressure therein was reduced to 100 Pa. Thereafter, they were heated at 170°C for 30 minutes, and cooled to 50°C. Then, the reduced pressure was eliminated, and they were removed from the vacuum oven. On the polyimide film removed from the vacuum oven, a copper thin film having metallic luster was formed.

The thickness of the copper thin film was measured to be 0.07 µm by an electrolytic thickness gauge.

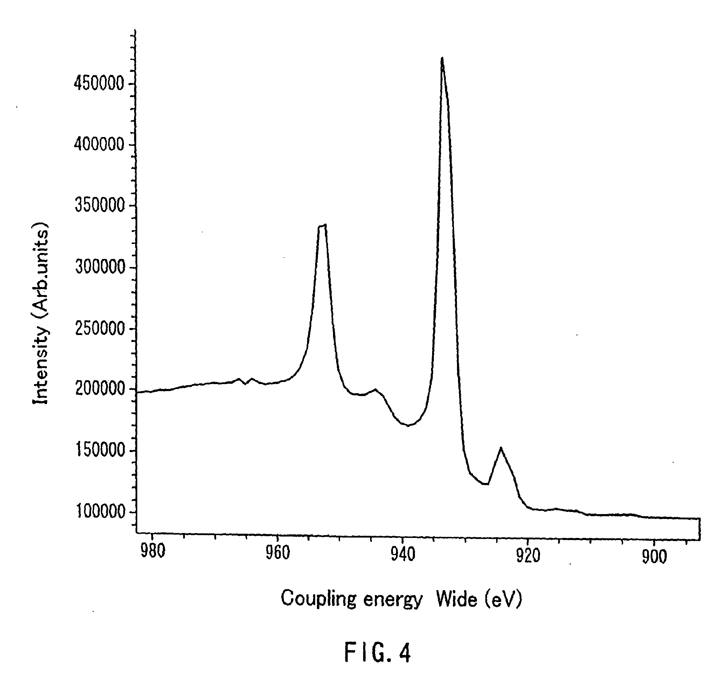

FIG. 4 shows the results of electronic spectroscopic chemical analysis (ESCA) of the copper thin film. Cu2p3/2 was detected at 933 eV, which was confirmed to be metallic copper.

The copper thin film thus obtained was used as a power supplying layer and subjected to electrolytic copper plating, using a copper sulfate plating bath. As a result, a copper-plated film was formed in the same way as in the case where a commercially available copper foil was used a power supplying layer.

### Example 4

The blue precipitate obtained in Example 2 was mixed with an equal amount of cyclohexanol to obtain a paste.

The paste thus obtained was applied uniformly to a glass epoxy substrate for a printed wiring board to 20 g/m². The glass epoxy substrate was placed in a vacuum oven, and the pressure therein was reduced to 10 kPa. Thereafter, the glass epoxy substrate was heated at 170°C for 30 minutes. Then, it was cooled to 50°C, and removed from the vacuum oven.

As a result, a brown copper thin film was formed on the glass epoxy substrate thus removed.

The thickness of the copper thin film was measured to be 0.38 µm with an electrolytic thickness gauge.

The copper thin film thus obtained was used as a power supplying layer, and subjected to electrolytic copper plating, using a copper sulfate plating bath. As a result, a copper-plated film was formed in the same way as in the case where a commercially available copper foil was used as a power supplying layer.

### Example 5

The blue precipitate obtained in Example 1 was dissolved in methanol, and applied to a glass substrate. Then, methanol was evaporated to deposit the precipitate on the glass substrate in an amount of 10 g/m².

The glass substrate was placed in an electric furnace, and the inside of the furnace was replaced by an inert atmosphere with nitrogen gas. Then, the glass substrate was heated at 170°C for 30 minutes, followed by cooling. When the glass substrate was cooled to 50°C or lower, it was removed from the furnace. As a result, a brown copper thin film was formed on the glass substrate thus removed.

The thickness of the copper thin film thus obtained was measured to be 0.12 µm with an electrolytic thickness gauge. The copper thin film thus obtained was used as a power supplying layer, and subjected to electrolytic copper plating using a copper sulfate plating bath. As a result, a copper-plated film was formed in the same way as in the case where a commercially available copper foil was used as a power supplying layer.

## Claims

1. A method for producing a copper thin film, comprising:
heating a copper compound at a temperature of 100°C to 300°C in a non-oxidizing atmosphere of copper; and
cooling the copper compound to 60°C or lower to form a copper thin film,
the copper compound having a decomposition temperature in a range of 100°C to 300°C and comprising one unit or an oligomer or polymer of units represented by the following Formula (1):
[R¹COO]ₙ[NH₃]ₘCuX¹ₚ (1)
where *n* is 1 to 3; *m* is 1 to 3; *p* is 0 to 1; *n* pieces of *R¹* respectively represent the following Formula (2), CH₂X², CH₂X²(CHX²)_{q}, NH₂, or H, and may be the same or different from each other, or n is 2 and two pieces of [R¹COO] represent together the following Formula (3); *R², R³,* and *R⁴* are respectively CH₂X², CH₂X²(CHX²)_{q}, NH₂, or H; *R⁵* is -(CHX²)ᵣ-; *X²* is H, OH, or NH₂; *r* is 0 to 4; *q* is 1 to 4; and *X¹* is NH₄⁺, H₂O, or solvent molecules 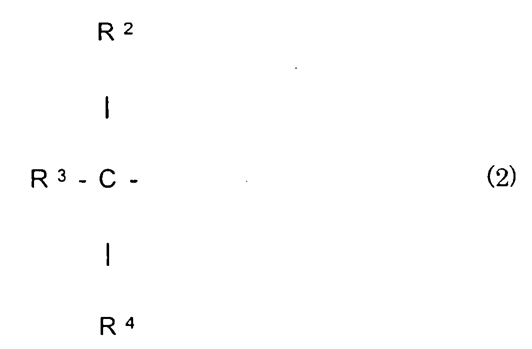
[-OOC-R⁵-COO-] (3).

2. The method for producing a copper thin film according to claim 1, wherein the non-oxidizing atmosphere is at least one selected from the group consisting of a reducing atmosphere, an inert atmosphere, a reduced-pressure atmosphere, and a supercritical atmosphere of a reducing gas and an inert gas.

3. The method for producing a copper thin film according to claim 1, wherein the Formula (1) is one unit or an oligomer or polymer of units represented by the following Formula (4):
[HCOO]_{n[}NH₃]ₘCuX¹ₚ (4)
where *n* is 1 to 3; *m* is 1 to 3; *p* is 0 to 1; *X¹* is NH₄⁺, H₂O, or solvent molecules.

4. The method for producing a copper thin film according to claim 1, wherein the Formula (1) is one unit or an oligomer or polymer of units represented by the following Formula (5):
[HCOO]₂[NH₃]₂CuX³ₚ (5)
where *p* is 0 to 1; and *X³* is H₂O or solvent molecules.

5. The method for producing a copper thin film according to claim 1, wherein the Formula (1) is one unit or an oligomer or polymer of units represented by the following Formula (6):
[R¹COO]₂[NH₃]₂Cu (6)
where two pieces of *R¹* may be the same as those of the Formula (1) or different therefrom.

6. The method for producing a copper thin film according to claim 1, wherein the Formula (1) is one unit or an oligomer or polymer of units represented by the following Formula (7):
[OOC-R⁵-COO][NH₃]₂Cu (7)
where *R⁵* is-(CHX²)ᵣ-.

## Patentansprüche

1. Verfahren zur Herstellung einer dünnen Kupferschicht umfassend:
Erhitzen einer Kupferverbindung bei einer Temperatur von 100°C bis 300°C in einer nicht-oxidierenden Atmosphäre von Kupfer; und
Abkühlen der Kupferverbindung auf 60°C oder niedriger, um eine dünne Kupferschicht auszubilden,
wobei die Kupferverbindung eine Zersetzungstemperatur im Bereich von 100°C bis 300°C besitzt und eine Einheit oder ein Oligomer oder Polymer von Einheiten umfasst, welche durch die folgende Formel (1) dargestellt sind:
[R¹COO]ₙ [NH₃]ₘCuX¹ₚ (1)
worin n gleich 1 bis 3 ist; m gleich 1 bis 3 ist; p gleich 0 bis 1 ist; jeweils n Stücke von R¹ die folgende Formel (2), CH₂X², CH₂X²(CH₂X²)_{q}, NH₂, oder H darstellen und gleich oder verschieden voneinander sein können, oder n gleich 2 ist und zwei Stücke von [R¹COO] zusammen die folgende Formel (3) darstellen; R², R³ und R⁴ jeweils CH₂X², CH² X² (CHX²)_{q}, NH₂ oder H sind; R⁵ gleich -(CHX²)ᵣ- ist; X² gleich H, OH oder NH₂ ist; r gleich 0 bis 4 ist; q gleich 1 bis 4 ist; und X¹ gleich NH₄⁺, H₂O oder Lösungsmittelmoleküle sind 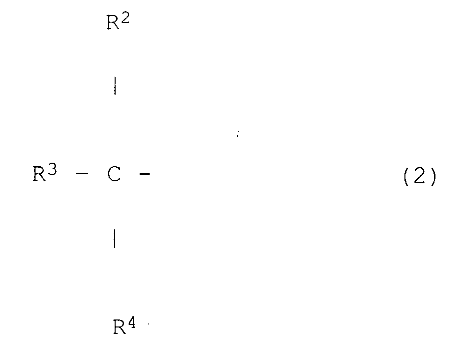
[-OOC-R⁵-COO-] (3).

2. Verfahren zur Herstellung einer dünnen Kupferschicht gemäß Anspruch 1, worin die nicht-oxidierende Atmosphäre wenigstens eine ist, die aus der Gruppe ausgewählt ist, bestehend aus einer reduzierenden Atmosphäre, einer inerten Atmosphäre, einer Atmospähre mit reduziertem Druck und einer superkritischen Atmosphäre eines reduzierenden Gases und eines Inertgases.

3. Verfahren zur Herstellung einer dünnen Kupferschicht gemäß Anspruch 1, worin die Formel (1) eine Einheit oder ein Oligomer oder ein Polymer von Einheiten ist, welche durch die folgende Formel (4) dargestellt ist:
[HCOO]ₙ[NH₃]ₘCuX¹ₚ (4)
worin n gleich 1 bis 3 ist; m gleich 1 bis 3 ist; p gleich 0 bis 1 ist; X¹ gleich NH₄⁺, H₂O oder Lösungsmittelmoleküle sind.

4. Verfahren zur Herstellung einer dünnen Kupferschicht gemäß Anspruch 1, worin die Formel (1) eine Einheit oder ein Oligomer oder Polymer von Einheiten ist, welche durch die folgende Formel (5) dargestellt ist
[HCOO]₂[NH₃]₂CuX³ₚ (5)
worin p gleich 0 bis 1 ist; und X³ gleich H₂O oder Lösungsmoleküle sind.

5. Verfahren zur Herstellung einer dünnen Kupferschicht gemäß Anspruch 1, worin die Formel (1) eine Einheit oder ein Oligomer oder Polymer einer Einheit ist, welche durch folgende Formel (6) dargestellt ist:
[R¹COO]₂[NH₃]₂Cu (6)
worin zwei Stücke von R¹ gleich wie jene der Formel (1) oder verschieden davon sein können.

6. Verfahren zur Herstellung einer dünnen Kupferschicht gemäß Anspruch 1, worin die Formel (1) eine Einheit oder ein Oligomer oder Polymer von Einheiten ist, welche durch die folgende Formel (7) dargestellt ist:
[OOC-R⁵-COO] [NH₃]₂Cu (7)
worin R⁵ gleich -(CHX²)ᵣ- ist.

## Revendications

1. Un procédé pour produire un film en cuivre mince, comprenant:
le chauffage d'un composé de cuivre, à une température de 100°C à 300°C dans une atmosphère non oxydante du cuivre; et
le refroidissement du composé de cuivre à 60°C ou moins, pour former un film en cuivre mince,
le composé de cuivre ayant une température de décomposition dans une fourchette de 100°C à 300°C et comprenant une unité ou un oligomère ou un polymère d'unités représentées par la formule (1) suivante:
[R¹COO]ₙ[NH₃]ₘCuX¹ₚ (1)
dans laquelle n vaut de 1 à 3; m vaut de 1 à 3; p vaut de 0 à 1; n éléments de R¹ représentent respectivement la formule (2) suivante, CH₂X², CH₂X²(CHX²)_{q}, NH₂, ou H, et peuvent être identiques ou différents les uns les autres, ou n vaut 2 et deux éléments de [R¹COO] représentent conjointement la formule (3) suivante ; R², R³, et R⁴ sont respectivement CH₂X², CH₂X² (CHX²)_{q}, NH₂, ou H; R⁵ est -(CHX²)ᵣ-; X² est H, OH, ou NH₂; r vaut de 0 à 4; q vaut 1 à 4; et X¹ est NH₄⁺, H₂O, ou des molécules de solvant 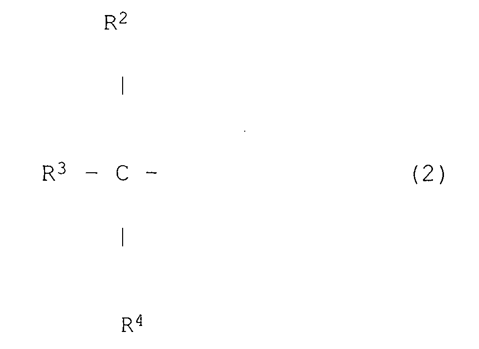
[-OOC-R⁵-COO-] (3).

2. Le procédé pour produire un film en cuivre mince selon la revendication 1, dans lequel l'atmosphère non oxydante est au moins sélectionnée dans le groupe composé d'une atmosphère réductrice, d'une atmosphère inerte, d'une atmosphère à pression réduite, et d'une atmosphère supercritique d'un gaz réducteur et d'un gaz inerte.

3. Le procédé pour produire un film en cuivre mince selon la revendication 1, dans lequel la formule (1) est une unité ou un oligomère ou un polymère d'unités représenté(e) par la formule (4) suivante:
[HCOO]ₙ[NH₃]ₘCuX¹ₚ (4)
dans laquelle n vaut de 1 à 3; m vaut de 1 à 3; p vaut de 0 à 1; X¹ est HH₄⁺, H₂O, ou des molécules de solvant.

4. Le procédé pour produire un film en cuivre mince selon la revendication 1, dans lequel la formule (1) est une unité ou un oligomère ou un polymère d'unités représenté(e) par la formule (5) suivante:
[HCOO]₂[NH₃]₂CuX³ₚ (5)
dans laquelle p vaut de 0 à 1; et X³ est H₂O, ou des molécules de solvant.

5. Le procédé pour produire un film en cuivre mince selon la revendication 1, dans lequel la formule (1) est une unité ou un oligomère ou un polymère d'unités représenté(e) par la formule (6) suivante:
[R¹COO]₂[NH₃]₂Cu (6)
dans laquelle deux éléments de R¹ peuvent être identiques à ceux de la formule (1) ou différents de ceux-ci.

6. Le procédé pour produire un film en cuivre mince selon la revendication 1, dans lequel la formule (1) est une unité ou un oligomère ou un polymère d'unités, représenté(e) par la formule (7) suivante:
[OOC-R⁵-COO][NH₃]₂Cu (7)
dans laquelle R⁵ est -(CHX²)ᵣ-.
